(19) Europäisches Patentamt
European Patent Office
Office européen des brevets

(11) **EP 4 056 732 A1**

(12) **EUROPEAN PATENT APPLICATION**

(43) Date of publication:
**14.09.2022 Bulletin 2022/37**

(21) Application number: **22161476.1**

(22) Date of filing: **10.03.2022**

(51) International Patent Classification (IPC):
**C23C 28/04** (2006.01)   **C23C 14/02** (2006.01)
**C23C 14/06** (2006.01)   **B23P 15/06** (2006.01)
**F16J 9/26** (2006.01)

(52) Cooperative Patent Classification (CPC):
**C23C 14/028; B23P 15/06; C23C 14/0605;
C23C 14/0641; C23C 28/04; C23C 28/044;
C23C 28/046; F16J 9/26**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **10.03.2021  IT 202100005666**

(71) Applicant: **Asso Werke S.r.l. Unipersonale
56012 Calcinaia (PI) (IT)**

(72) Inventor: **ANGUILLESI, Dimitri
56010 San Giovanni alla Vena  Vicopisano (PI) (IT)**

(74) Representative: **Primiceri, Maria Vittoria et al
Praxi Intellectual Property S.p.A.
Via Leonida Bissolati, 20
00187 Roma (IT)**

(54) **SURFACE TREATMENT OF PISTON RINGS**

(57)    The invention relates to a piston ring of an internal combustion engine which has a surface coating carried out on the contact area of the piston ring with the engine cylinder and which comprises a first outer layer of DLC with a thickness of 0.002 ± 0.001 mm and a second layer, underlying said first layer, based on chromium nitrides with a thickness of 0.014 ± 0.005 mm.

**EP 4 056 732 A1**

Processed by Luminess, 75001 PARIS (FR)

**Description**

Technical field of the invention

The invention refers to a surface treatment of piston rings. The treatment gives increased surface hardness and wear resistance.

More specifically, the invention refers to a surface coating or multilayer PVD type coating for piston rings (or piston sealing components) for applications on 2 and 4-stroke engines or where sealing piston rings can be used. The treatment according to the invention (also referred to as "PVD PLUS") is a coating that confers a particular wear resistance on the outer surface of the piston ring (the one in contact with the cylinder) and increased surface hardness.

Prior art

The piston rings, or sealing piston rings also called piston sealing components, are open metal piston rings positioned around the piston head of internal combustion engines to make it perfectly match the internal surface of the cylinder. These piston rings are metal piston rings inserted in special seats generally obtained in the upper part of the piston.

The surface coating treatment of the outer surface of the piston rings by means of PVD (Pressure Vapor Deposition) coating is known; it is in fact known to produce piston rings both in cast iron and in steel which have surface coatings obtained by PVD treatment on the sliding surface.

In fact, the piston rings, both those in cast iron and in steel, are not suitable for maintaining their functionality of sealing against the gases produced by combustion if their external surface is not suitably coated. The coating helps to withstand the wear resistance loads resulting from the high contact pressures against the walls of the engine cylinder; furthermore, if the cylinder is made with coating technologies that are particularly hostile or aggressive towards the piston ring, such as modern plasma coatings with a high content of chromium or tungsten powders, or coatings in nickel and silicon carbides, it is easy to have premature wear of the outer surface of the piston rings themselves with consequent loss of sealing functionality.

The piston rings, both those in cast iron and those in steel, have hardnesses ranging from 200 to 600 Vickers points, very far from the more than 1000 Vickers points obtained with PVD coatings.

The PVD coating is generally performed on the piston rings through carbon deposition with PVD (Pressure Vapor Deposition) techniques, however when the piston rings are made of cast iron the main difficulty is to obtain an adequate guarantee of adhesion of the coating to the substrate, as cast iron, containing graphite (amorphous material), does not allow the correct adhesion of the carbon coating, and its maintenance over time.

Also known are spheroidal cast iron piston rings with chromium nitride (CrN) or CNI coating (trade name of the CrN coating by the supplier Oerlikon). These coatings are obtained by deposition with arc or sputtering technology which allows to encapsulate the outer surface of the piston ring, including the graphite nodules.

Unfortunately, chromium-based coatings such as CrN, CNI hard chromium are not suitable for use on cylinders with coatings based on chromium powders, as they are a strong tribological antagonist, therefore wear is strong and premature in chromium on chromium contact.

In recent years, a new generation of PVD technique has been developed based on an amorphous structure, similar to the diamond structure. The resulting coatings are called DLC (Diamond Like Carbon) coatings. The properties of the DLC, having a hardness over 2000 vickers points, make it an amorphous, extremely compact and corrosion resistant coating, creating a real barrier against chemical agents. Thanks to the properties deriving from the $sp^3$ bond (diamond) and from the $sp^2$ bond (graphite), DLC is an electrical insulator, as well as an ideal anti-friction coating, thanks to the sliding surfaces that compose it. However, due to the technological limitations due to the low thicknesses that can be obtained, this technique cannot be used directly on spheroidal cast iron, as the adhesion of these carbon layers is difficult and wear resistance is extremely poor. Therefore, the direct application of carbon layers on piston rings made of spheroidal cast iron is particularly difficult.

US 2019/154153 A1 describes the physical vapor deposition of DLC on a chromium nitride based layer. However, the substrate is made up of piston rings of steel and not of cast iron. The reference to cast iron is evidently erroneous as it is stated that the outer annular surface of the piston ring is made of stainless steel containing 10% to 17% chromium, the rest being cast iron and carbon steel.

TAS MO ET AL ("Roles of mirror-like surface finish and DLC coated piston rings on increasing scuffing resistance of cast iron cylinder liners", WEAR, ELSEVIER SEQUOIA, LAUSANNE, CH, 15 June 2017 (2017-06-15), XP085091674 , ISSN: 0043-1648, DOI: 10.1016/J.WEAR.2017.01.110) describes a generic coating system, in which the material the piston ring is made of is not known.

US 2015/132539 A1 refers to a hard terminal layer which must be applied to an essentially smooth surface (obtained by polishing), but does not mention cast iron as a material on which the depositions of the various layers can be carried out.

US 2018/283553 A1 describes surface treatments by sandblasting or lapping in the context of the piston rings coating, but does not provide any indication of the material the piston rings are made of.

KHADEM MAHDI ET AL: "Tribology of multilayer coatings for wear reduction: A review", FRICTION, vol. 5, 1 January 2017 (2017-01-01), pages 248-262, XP055858681, DOI: 10.1007/s40544-017-0181-7. Retrieved from the Internet: URL: https://link.sppiston ringer.com/content/pdf/10.1007/s40544-017-0181-7.pdf describes a generic coating system, in which the material the piston ring is made of is not known.

US 2017/016537 A1 does not provide details on how to obtain wear-resistant coatings for piston rings made of cast iron.

None of the cited documents teaches how to obtain bonded, non-tensioned and non-brittling coatings on cast iron piston rings nor does it provide indications on how to prepare the outer surface of cast iron piston rings for optimal deposition. In particular, none of the prior art documents teaches to lap the surface of the cast iron piston rings before the various deposition treatments.

It should be considered that cast iron, in particular spheroidal cast iron, is by its nature difficult to treat due to the presence of graphite which makes it greasy and as such difficult to cover with hard coatings such as those based on nitrides and carbon, which easily detach from the outer surface of the piston ring when it is not properly treated.

DLC (Diamond like Carbon) is a class of amorphous carbon materials that exhibit some of the typical properties of diamond. DLC is usually applied as a coating of artifacts in other materials. [https://en.wikipedia.org/wiki/Diamond-like_carbon]

The present invention is aimed at overcoming the drawbacks, limitations and disadvantages of the state of the art.

If not specifically excluded in the detailed description that follows, what is described in this chapter is to be considered as an integral part of the detailed description.

Summary of the invention

It has now been found that by suitably combining polishing stages and fine abrasion stages, applied to the cast iron piston rings before and during the surface treatments of nitriding and subsequent carbon application, it is possible to obtain coatings with not only high hardness and resistance to stress, but also firmly anchored to the underlying layers of the cast iron.

It has also been experimentally found that the polishing operation of the CrN layer, performed following the lapping of the cast iron surface, helps and increases the adhesion of the layers to each other and makes the coating carried out on the cast iron piston rings more durable overall, in particular those made of spheroidal cast iron.

Therefore, the drawbacks of the state of the art are overcome by carrying out a nitriding on the outer surface (the one in contact with the cylinder) of the spheroidal cast iron piston ring. A carbon layer is then applied to the nitrided layer in order to obtain an increase in surface hardness, up to 4000 HV of Vikers hardness or more, and an increased wear resistance, said successive layers being carried out in sequence after lapping and subsequent sandblasting or shot peening to obtain an optimal micro-roughness.

The thickness of the nitriding layer, or intermediate layer, is about $0.014 \pm 0.005$ mm and the carbon layer, or outer layer, is about $0.002 \pm 0.001$ mm.

The process of the invention allows for adherent, non-tensioned and non-brittling coatings.

The application of the intermediate CrN layer and the external carbon layer is performed with the PVD technique.

It is therefore an object of the present invention to provide a piston ring provided with an external carbon layer, also called DLC (Diamond Like Carbon), and an intermediate layer of chromium nitride. Said double layer is extremely adherent, measured with scratch test and drop test (specific VDI 3198 Mercedes regulation), to the spheroidal cast iron the piston ring is made of.

Further aspects, purposes and advantages of the ring and the related nitriding process will become evident from the detailed description of the invention that follows.

The claims describe preferred variants of the invention, forming an integral part of this description.

Brief description of the Figures

Features and advantages of the invention will be set out in the following description also with the aid of the drawings wherein:

Figure 1 schematically represents a piston ring A, and the details X, Y and Z wherein the detail X illustrates the section of the profile of the seat of the set screw, the detail Y illustrates the section along AA of the piston ring A with the external surface (S) provided on the peripheral ends of a chamfer (R) with a logarithmic course and detail Z illustrates a plan section of the grain seat;

Figure 2 represents the logarithmic profile of the chamfer (R);

Figure 3A is the micrograph of the DLC coating, 500X magnification, the thicknesses are indicated;

Figure 3B is the micrograph of the CNI coating, 500X magnification, the thicknesses are indicated;

Figure 3C is the micrograph of the DLC + CNI coating, 500X magnification, the thicknesses are indicated;

Figure 3D is the micrograph of the DLC + CNI coating shown in Figure 3C, 1000X magnification, the thicknesses are indicated.

Detailed description of the invention

In the context of the invention, the term piston ring or piston rings means the piston sealing components, and the terms piston ring and piston sealing component are to be considered equivalent.

The piston is an element of an internal combustion engine, which can for example be an automobile or motorcycle engine, two or four stroke, or a boxer engine, and will typically be a high-performance engine, such as a sports and/or racing cars' engine. The piston can be made of aluminum alloy or steel or other materials (composites, sintered, etc.) per se known.

The piston rings allow the piston to have a better seal of the pressure that develops inside the combustion chamber of the internal combustion engine, sealing it.

The piston rings have the shape of an open ring. This piston ring can be circular or oval (in the case of pistons which are also oval).

The section of the piston rings can be rectangular, trapezoidal, "L" or have other shapes.

Another important parameter is the height of the piston ring: the thicker it will be, the more it will exert a force on the cylinder wall, improving sealing but also increasing wear. Another way to increase the sealing is to apply more piston rings on the piston. Typically, the piston rings have variable thicknesses between 0.8 and 2.5 mm.

Furthermore, the ends of the piston rings can have a flat (they end with a profile perpendicular to their length), slant (the end profile is inclined), scaled (the end part takes a step shape) shape.

The piston rings according to the invention are made of cast iron, preferably of spheroidal cast iron. The graphite spheroids present in the cast iron give it a natural greasiness so that they do not favor the adhesion of the coating to the substrate, in fact, as mentioned, the wear resistance of said piston rings is poor, wear which is due to the sliding of the piston and, consequently, of the piston rings on the cylinder walls. As mentioned above, the hardening of the external surface of the spheroidal cast iron piston rings is difficult due to the nature of the cast iron and the application of surface layers of carbon is impractical.

Still in the context of the present invention, the term lapping means a mechanical operation that is performed on a surface to minimize its roughness using suitable abrasives and lapping fluids per se known. The general purpose of lapping is to eliminate the slightest roughness of the surface and the technique is known to those skilled in the art.

In turn, polishing makes it possible to improve surface roughness and remove scratches after lapping or after the entire polishing process, including sandblasting and shot peening. This technique is also known to those skilled in the art.

To simplify concepts, lapping is used to smooth the surface and polishing is the finishing process that is usually performed after lapping. Hence, it is the process of making the treated surface similar to glass and minimizing scattering.

The roughness Ra is defined as the arithmetic mean value of the deviations (taken as an absolute value) of the real surface profile with respect to the mean line. Then the average value, expressed in microns, of the ordinates, y1, y2, y3, .....yn, of the profile with respect to the mean line is examined. This parameter is known to those skilled in the art.

The roughness Rz is defined as the distance between two lines parallel to the mean line passing on average between the five highest peaks and the five lowest valleys, within the limits of the base length. To calculate the Rz parameter, the average absolute value of the height, Yp, of the five highest peaks measured from the mean line (therefore: yp1, yp2, yp3, yp4, yp5), and the absolute average value of the height, Yv, of the five deepest valleys (therefore: yv1, yv2, yv3, yv4, yv5) are considered. Added together these values form the roughness parameter Rz which practically is an average over ten points of maximum irregularity. This parameter is also known to those skilled in the art.

It has now been found that the interposition of a chromium nitride layer allows a compatibilization between the spheroidal cast iron surface and the carbon layer (DLC). It has also been experimentally found that if the nitriding is not performed on a suitably treated surface, the adhesion is poor.

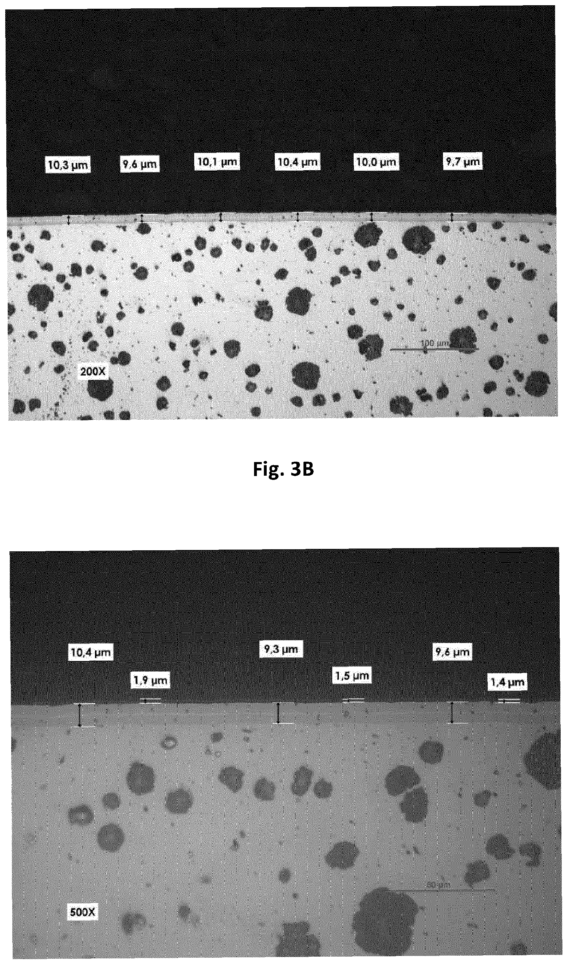

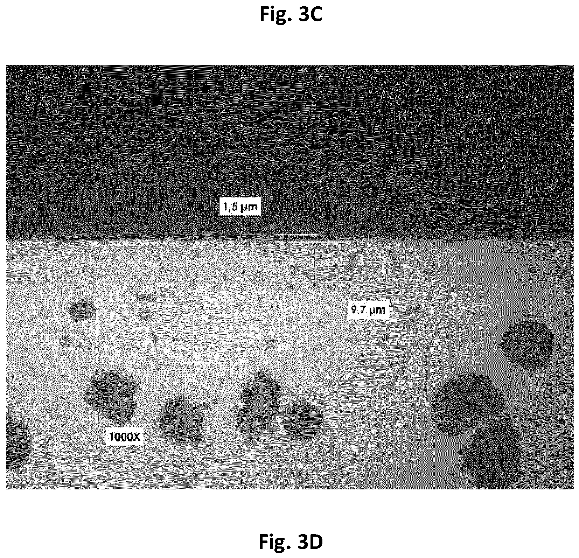

In the following, the surface coating based on chromium nitrides (CrN) and DLC according to the invention will also be called DLC/CrN coating, therefore the two terms are to be considered synonymous. A non-limiting example of the DLC/CrN coating is illustrated in the micrographs of Fig. 3C-3D.

Advantageously, the surface coating process based on chromium nitrides (CrN) and DLC according to the invention is carried out with conventional PVD techniques and with known equipment. In the case of PVD (Physical Vapor Deposition), the generation takes place physically by evaporating, (with reference to the invention) Cr in a nitrogen flow environment to obtain the required coating layer. The transport from the sources of the metal (in the present case Cr) to the parts to be treated (in the present case the surfaces of the piston rings to be treated) takes place through a vapor, or plasma (inside the treatment chamber, a low pressure ionized gas is generated, in the present case nitrogen, to allow the deposition of CrN). For the purposes of the present invention all PVD techniques are suitable, sputtering is preferred.

Deposition is favored by the presence of an electric field.

The PVD techniques applicable according to the invention are several, but can be briefly divided into solid source techniques (cathodic depositions, such as arc or sputtering) and melted source techniques (such as evaporation by joule effect or by electron gun). PVD techniques are all known to those skilled in the art, the preferred techniques are arc and sputtering.

The PVD deposition process according to the invention comprises the following steps:

- Lapping the outer surface of the piston rings, for example with mineral oil mixed with corundum of 160/250 grain size, then washing carefully and drying under vacuum to eliminate traces of humidity so that no oxides are formed on the treated surface (the outer surface of the piston rings is advantageously the surface which meets the internal surface of the cylinder); in this step it is preferable that the roughness Ra is lower than 0.15 $\mu$m preferably <0.12 $\mu$m, more preferably <0.1 $\mu$m;

- Mounting the piston rings on a cylinder (which can have a circular or oval section) (spindle) having the same shape as the internal profile (internal circumference) of the piston ring in order to copy it perfectly (preferably several piston rings stacked one on top of the other with the flat faces of the internal circumference in contact with the spindle and suitably tightened with external flanges);

- Rotating the piston rings so prepared (for example about 60 rpm) and subjecting them to a sandblasting or micro shot peening treatment, typically with glass microspheres with a grain size of 150-300 $\mu$m depending on the hardness of the cast iron of the piston ring; the roughness obtained is of the same order of magnitude as the previous step; In this step, the sandblasting or shoot peening times according to the invention are regulated by the empirical relationship:

$$T_{(\text{time in sec})} = n_{(\text{number of spindle revolutions})}\, d_{(\text{total diameter of the piston rings mounted on the spindle in mm})}\, L_{(\text{spindle length in mm})}\, \text{hardness}_{(\text{HRB})} / 100$$

(hardness is measured in HRB points according to the Rockwell B hardness scale)

- Inserting the piston rings so perfectly cleaned and mounted on the spindle in the oven of the PVD device and, in conditions of high vacuum and ionization in plasma flow, depositing CrN on the pieces to be treated; the treatment is carried out until a first layer based on chromium nitrides (such as CNI) with a thickness of 0.014 ± 0.005 mm (14 ± 5 $\mu$m) is obtained; the conditions for carrying out this step are within the knowledge of the person skilled in the art;

increasing the thickness (always in the range 0.014 ± 0.005 mm), the roughness increases, these roughnesses are then leveled through a polishing step, carried out on the piston rings extracted from the vacuum chamber to lower the roughness to values of Ra ≤0.2 $\mu$m, preferably lower than 0.15 $\mu$m, preferably <0.12 $\mu$m, more preferably <0.1 $\mu$m, and Rz ≤1 $\mu$m;

it is to be noted that the Rz value is particularly important as the indicated value minimizes the so-called "grater" effect of two surfaces that rub against each other, in fact the harder the coating on the piston ring, the easier it is to abrade the antagonist surface of the cylinder and a restrained value of Rz indicates that this "grater" effect is minimized;

- Inserting the piston rings, treated and polished in the previous step, again in the vacuum chamber of the PVD device for the deposition of a second layer with the DLC technique; a second layer in DLC carbon with a thickness of 0.002 ± 0.001 mm (2 ± 1$\mu$m) is thus obtained; the conditions for carrying out this step are within the knowledge of the person skilled in the art;

- Optionally, one or more further final polishing steps can be performed.

With the process detailed above it is possible to obtain a piston ring provided with an internal nitride layer obtained by vaporization of a nitride, preferably chromium nitride. This layer was found to be suitable for adhesion to spheroidal cast iron. The outer layer, applied on the Cr nitride layer, is a DLC layer suitable for wear resistance even towards carburizing or chromium-based elements. Said double layer is extremely adherent to the cast iron and is particularly effective in providing ring resistance to scuffing or chipping of the coating during the passage of the piston ring over the ports.

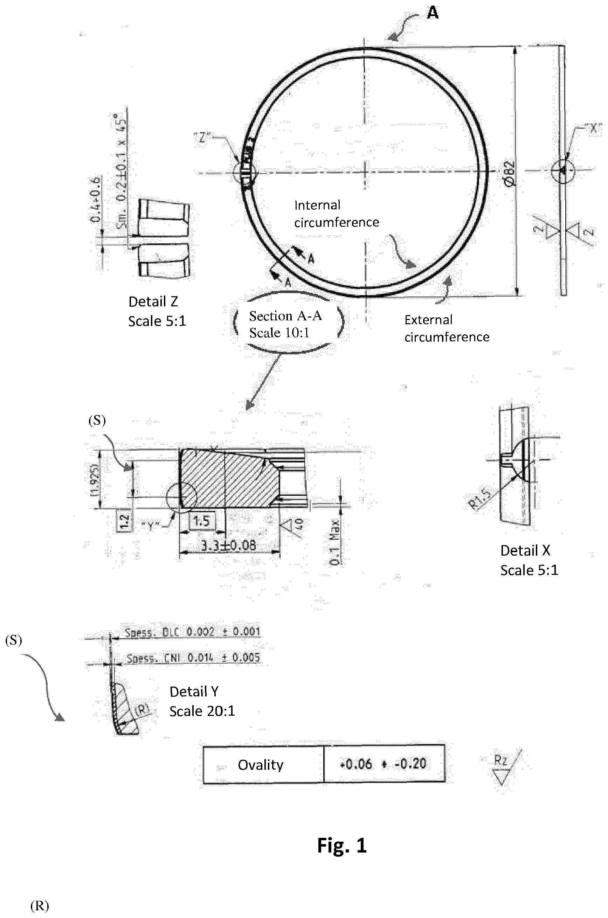

With particular reference to Fig. 1, a piston ring A in the form of a circular piston ring is schematically shown, provided with a first surface indicated as Internal circumference and with a second surface, indicated as External circumference.

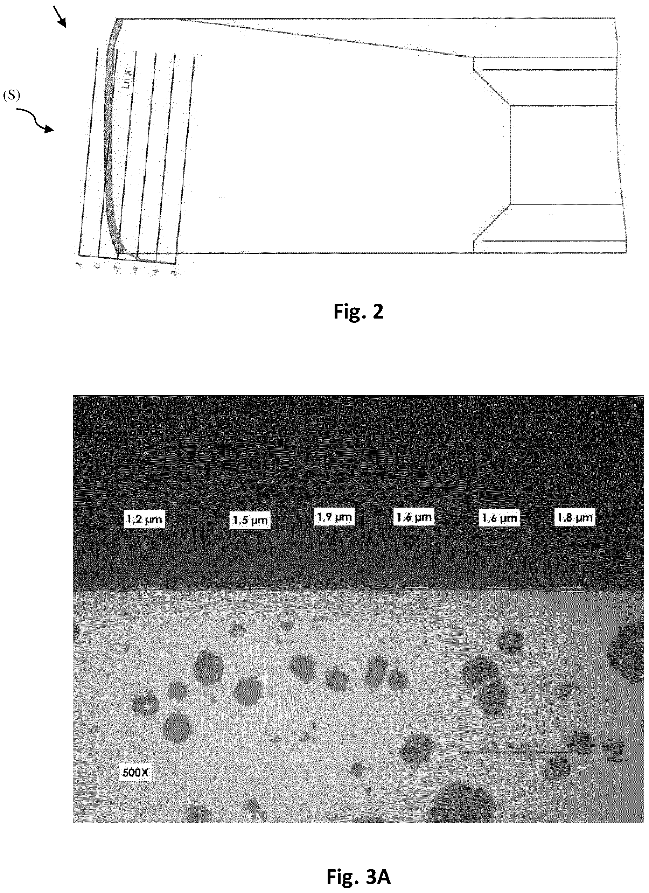

In particular, as illustrated in detail Y of Fig. 1 and in Fig. 2, the second surface or external circumference of the piston ring A of the invention has a surface (S) facing the cylinder (not shown) and able to oppose its internal surface. The surface (S) is treated with the process of the invention and has the DLC/CrN coating illustrated in (but not limited to) the micrographs of Fig. 3A-3D. Said surface (S) is also provided on its peripheral ends with a chamfer (R) with a logarithmic profile which runs along the entire circumference of said peripheral ends of the surface (S). This chamfer (R) allows an accurate and perfect adhesion of the DLC/CrN coating on the sides of the piston ring, preventing it from detaching during operation.

The external logarithmic profile (R) allows to minimize the impact of piston ring A against the ports of the transfer ports, present in 2-stroke engines, but still allows a deposition with a negative gradient from the center towards the edges of the surface (S) or External circumference of piston ring A, so as to have a deposit with decreasing and negligible thickness at the ends of the chamfers (R), which otherwise could create burrs and/or cracks or chips during the operation of the piston ring itself.

The high thickness of the chromium nitride layer helps to strengthen the spheroidal cast iron substrate of piston ring A, creating a sort of robust armor so as to isolate the substrate from the Hertzian pressures that are inevitably generated during operation and which could also create detachments of the DLC/CrN coating from the substrate itself. This nitrided layer also contributes to create an optimal rigid structure to accommodate the deposition of DLC (very few microns) which would otherwise be chipped and damaged at the first impact or contact.

With the present invention it is possible to deposit a coating such as DLC on a spheroidal cast iron, for piston rings intended for high performance engines such as 2-stroke engines with the presence of transfer ports, so as to allow use in engines that have tribological antagonism problems towards the chromium element, such as Sumebore® or similar coatings in chromium carbide, tungsten powders.

With particular reference to a non-limiting embodiment of the present invention, a piston ring is shown in Figure 1, indicated generically with A. It has a circular shape (but it could also be oval, a shape usually used for some types of motors) and has a generically trapezoidal section. The piston ring A has an upper surface and a lower surface and is provided with an internal circumference and an external circumference (indicated with S) with corresponding internal and external surfaces, with respect to the piston (not shown) on which the piston ring can be housed. The surface of the internal circumference of piston ring A corresponds to the external lateral surface of the piston while the surface of the external circumference (S) corresponds to the internal surface of the engine cylinder (also not shown).

In Fig. 1 detail Y schematically shows the chamfer (R) of piston ring A facing outwards and positioned on the external circumference (S) of the piston ring, intended to come into contact with the internal walls of the cylinder. The chamfer (R) has a generally curved profile, preferably with an angle of 25-45°. Particularly preferred is a logarithmic profile, ideal for optimization with regard to chipping and/or scuffing.

In practice, sharp edges must be avoided, i.e. the joints between the coated and uncoated surfaces must be rounded.

The improving effects on the adhesion of the coating can be observed in the micrographs of Fig, 3A-3D. From the micrographs it is evident how lapping, which affects the joint between the cast iron piston and the CrN layer, and polishing, which affects the joint between the CrN layer and the DLC layer, allow to obtain joints without asperities and discontinuities which give such an adhesion that the detachment of the CrN/DLC coating is reduced to a minimum. That is, the smoother the surfaces, the greater the adhesion of the coatings and this is evident from the micrographs, which do not show discontinuities or jaggednesses.

Implementation variants of the described non-limiting example are possible, without however departing from the scope of protection of the present invention, including all the equivalent embodiments for a person skilled in the art, to the content of the claims.

From the above description, together with his knowledge, the person skilled in the art is able to achieve the object of the invention without having to introduce further details.

**Claims**

1. A process for the surface coating of piston rings made of spheroidal cast iron, said process being performed with the PVD (Physical Vapor Deposition) technique and comprising the steps of:

   - Performing a lapping operation on the outer surface of the piston rings, with subsequent washing and drying;
   - Mounting the piston rings on a cylindrical spindle having the same shape as the internal profile of the piston rings in order to copy it perfectly;
   - Rotating the piston rings thus prepared and subjecting them to a sandblasting or shot peening treatment;
   - Inserting the piston rings thus treated and mounted on the spindle in the oven of a PVD device and carrying out a deposition of chromium nitrides until obtaining a layer of nitrides with a thickness of 0.014 ± 0.005 mm;
   - At the end of the deposition of the nitrides, polishing the nitrided piston rings until a roughness of Ra ≤0.2 μm and Rz ≤1 μm is obtained;
   - Transferring the piston rings thus treated and polished again into the vacuum chamber of the PVD device for the deposition of a layer of Diamond Like Carbon (DLC) until a DLC layer with a thickness of 0.002 ± 0.001 mm is obtained.

2. The process according to claim 1 wherein further one or more polishing steps are carried out.

3. The process according to any one of claims 1-2 wherein the blasting times are driven by the empirical relationship:

$$T_{(time\ in\ sec)} = n_{(number\ of\ spindle\ revolutions)}\ d_{(total\ diameter\ of\ the\ piston\ rings\ mounted\ on\ the\ spindle\ in\ mm)}$$

$$L_{(spindle\ length\ in\ mm)}\ hardness_{(HRB)}\ /\ 100$$

   where hardness is measured in HRB points according to the Rockwell B hardness scale.

4. The process according to any one of claims 1-3 wherein the lapping is carried out until a roughness Ra lower than 0.15 μm preferably <0.12 μm, more preferably <0.1 μm is obtained.

5. The process according to any one of claims 1-4 wherein the sandblasting or shot peening operation is carried out until a roughness Ra of less than 0.15 μm is obtained, preferably <0.12 μm, more preferably <0.1 μm.

6. The process according to any one of claims 1-5 wherein the polishing is carried out until the roughness of the chromium nitride layer is lowered to a roughness Ra ≤0.2 μm, preferably lower than 0.15 μm, preferably <0.12 μm, more preferably <0.1 μm, and Rz ≤1 μm.

7. The process according to any one of claims 1-6 wherein the surface coating is performed on the contact zone of the piston ring with the cylinder of an engine and comprises a DLC external layer and an underlying layer of chromium nitrides.

8. A piston ring of an internal combustion engine which bears a surface coating carried out on the contact area of the piston ring with the engine cylinder and which comprises a first DLC external layer with a thickness of 0.002 ± 0.001 mm and a second layer, underneath said first layer, based on chromium nitrides with a thickness of 0.014 ± 0.005 mm.

9. The piston ring according to the preceding claim wherein the connection between the coated and uncoated surfaces is not sharp-edged but rounded with a generally curved profile, preferably with an angled curvature of 25-45°.

10. The piston ring according to the preceding claim wherein the profile has a logarithmic profile.

11. The piston ring according to any one of claims 8-10 which is in a circular or oval open ring shape.

12. A piston comprising at least one piston ring according to any one of claims 8-11.

13. A cylinder and piston assembly wherein the piston comprises at least one piston ring according to any one of claims 8-11.

**14.** A two or four stroke engine comprising at least one piston according to claims 12 or 13.

**Fig. 1**

**Fig. 2**

**Fig. 3A**

**Fig. 3B**

**Fig. 3C**

**Fig. 3D**

Europäisches
Patentamt
European
Patent Office
Office européen
des brevets

# EUROPEAN SEARCH REPORT

Application Number

EP 22 16 1476

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/154153 A1 (AVELAR ARAUJO JULIANO [BR] ET AL) 23 May 2019 (2019-05-23) | 8-14 | INV. C23C28/04 |
| Y | * paragraphs [0037], [0043], [0044]; figure 2a * | 1-7 | C23C14/02 C23C14/06 B23P15/06 |
| X | TAS M O ET AL: "Roles of mirror-like surface finish and DLC coated piston rings on increasing scuffing resistance of cast iron cylinder liners", WEAR, ELSEVIER SEQUOIA, LAUSANNE, CH, 15 June 2017 (2017-06-15), XP085091674, ISSN: 0043-1648, DOI: 10.1016/J.WEAR.2017.01.110 * page 1560; figure 3a * | 8-14 | F16J9/26 |
| Y | US 2015/132539 A1 (BAILEY JEFFREY R [US] ET AL) 14 May 2015 (2015-05-14) * paragraph [0370] * | 1-7 | |
| A | US 2018/283553 A1 (SMITH THOMAS J [US] ET AL) 4 October 2018 (2018-10-04) * the whole document * | 1-14 | |
| A | KHADEM MAHDI ET AL: "Tribology of multilayer coatings for wear reduction: A review", FRICTION, vol. 5, 1 January 2017 (2017-01-01), pages 248-262, XP055858681, DOI: 10.1007/s40544-017-0181-7 * page 250, left-hand column, paragraph 3 * | 8 | **TECHNICAL FIELDS SEARCHED (IPC)** C23C B23P F16J |
| A | US 2017/016537 A1 (BAERENREUTER DIRK [DE]) 19 January 2017 (2017-01-19) * paragraph [0002]; claim 8 * | 1 | |

The present search report has been drawn up for all claims

| Place of search | Date of completion of the search | Examiner |
|---|---|---|
| The Hague | 15 July 2022 | Schuhmacher, Jörg |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 16 1476

This annex lists the patent family members relating to the patent documents cited in the above-mentioned European search report.
The members are as contained in the European Patent Office EDP file on
The European Patent Office is in no way liable for these particulars which are merely given for the purpose of information.

15-07-2022

| Patent document cited in search report | | Publication date | Patent family member(s) | | Publication date |
|---|---|---|---|---|---|
| US 2019154153 | A1 | 23-05-2019 | BR | 102016015392 A2 | 16-01-2018 |
| | | | CN | 109477575 A | 15-03-2019 |
| | | | DE | 112017003285 T5 | 28-03-2019 |
| | | | US | 2019154153 A1 | 23-05-2019 |
| | | | WO | 2018002072 A1 | 04-01-2018 |
| US 2015132539 | A1 | 14-05-2015 | NONE | | |
| US 2018283553 | A1 | 04-10-2018 | US | 2018283553 A1 | 04-10-2018 |
| | | | US | 2019264809 A1 | 29-08-2019 |
| | | | WO | 2018177900 A1 | 04-10-2018 |
| US 2017016537 | A1 | 19-01-2017 | CN | 105934613 A | 07-09-2016 |
| | | | DE | 102014003149 A1 | 10-09-2015 |
| | | | EP | 3114375 A1 | 11-01-2017 |
| | | | JP | 6556159 B2 | 07-08-2019 |
| | | | JP | 2017508925 A | 30-03-2017 |
| | | | KR | 20160128324 A | 07-11-2016 |
| | | | PT | 3114375 T | 26-07-2018 |
| | | | RU | 2670477 C1 | 23-10-2018 |
| | | | US | 2017016537 A1 | 19-01-2017 |
| | | | WO | 2015131872 A1 | 11-09-2015 |

EPO FORM P0459

For more details about this annex : see Official Journal of the European Patent Office, No. 12/82

**EP 4 056 732 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2019154153 A1
- US 2015132539 A1
- US 2018283553 A1
- US 2017016537 A1

**Non-patent literature cited in the description**

- Roles of mirror-like surface finish and DLC coated piston rings on increasing scuffing resistance of cast iron cylinder liners. **TAS MO et al.** WEAR. ELSEVIER SEQUOIA, 15 June 2017
- **KHADEM MAHDI et al.** Tribology of multilayer coatings for wear reduction: A review. *FRICTION,* 01 January 2017, vol. 5, 248-262